(19) Europäisches Patentamt
European Patent Office
Office européen des brevets

(11) EP 4 760 317 A1

(12) EUROPEAN PATENT APPLICATION
published in accordance with Art. 153(4) EPC

(43) Date of publication:
17.06.2026 Bulletin 2026/25

(51) International Patent Classification (IPC):
$G01R\ 31/396^{(2019.01)}$ $G01R\ 31/3835^{(2019.01)}$
$G01R\ 19/165^{(2006.01)}$ $G01R\ 19/30^{(2006.01)}$

(21) Application number: 25754581.4

(22) Date of filing: 07.02.2025

(52) Cooperative Patent Classification (CPC):
G01R 19/165; G01R 19/30; G01R 31/3835;
G01R 31/396

(86) International application number:
PCT/KR2025/001820

(87) International publication number:
WO 2025/173992 (21.08.2025 Gazette 2025/34)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 15.02.2024 KR 20240021601

(71) Applicant: LG Energy Solution, Ltd.
Seoul 07335 (KR)

(72) Inventors:
• LEE, Seul Gi
  Daejeon 34122 (KR)
• KIM, Young Jin
  Daejeon 34122 (KR)
• CHOI, Jee Soon
  Daejeon 34122 (KR)

(74) Representative: Goddar, Heinz J.
Boehmert & Boehmert
Anwaltspartnerschaft mbB
Pettenkoferstrasse 22
80336 München (DE)

(54) BATTERY DIAGNOSIS DEVICE AND OPERATING METHOD THEREOF

(57) A battery diagnosis device according to an embodiment disclosed in this document may include an acquisition unit that acquires pack data related to a state of a battery pack and cell data related to a state of a plurality of battery cells included in the battery pack, an identification unit that identifies, based on the pack data, a first OCV section in which a voltage standard score (Z-Score) difference between the plurality of battery cells decreases as an open circuit voltage (OCV) of the battery pack increases and a second OCV section in which the voltage standard score difference between the plurality of battery cells increases as the OCV of the battery pack increases, an extraction unit that extracts, based on the cell data, a diagnostic feature value from voltage standard scores of the plurality of battery cells corresponding to each of the first OCV section and the second OCV section and a diagnosis unit that diagnoses an abnormality of the battery pack based on the extracted diagnostic feature value.

FIG.1

EP 4 760 317 A1

**Description**

## TECHNICAL FIELD

### Cross-reference to Related Applications

This application claims priority from Korean Patent Application No. 10-2024-0021601, filed on February 15, 2024, the disclosures of which are incorporated by reference herein.

### Technical Field

Embodiments disclosed in this document relate to a battery diagnosis device and an operating method thereof.

## BACKGROUND ART

Recently, research and development on secondary batteries have been actively conducted. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

In addition, the secondary batteries may generally be used as a battery pack that includes battery modules in each of which a plurality of battery cells are connected in series and/or in parallel. Also, the secondary batteries may be used as a battery rack that includes a plurality of battery modules and a rack frame that accommodates these battery modules.

Such battery cells, battery modules, battery packs, or battery racks may be utilized in various devices. For example, batteries may be utilized in mobile devices such as mobile phones, laptop computers, smart phones, and smart pads, but also in the field of electric vehicles (EVs, HEVs, PHEVs) and large-capacity power storage devices (ESS).

The state and operation of these batteries may be managed and controlled by a battery management system (BMS). The battery management system may be included together with a battery within a single device.

In addition, the battery management system may manage and control the battery while being separated from a device including the battery. For example, the battery management system may be implemented as a separate server device. In this case, the battery management system may collect battery data and vehicle data from vehicles, etc., and manage and control the battery using the collected data.

## DISCLOSURE OF THE INVENTION

### TECHNICAL PROBLEM

Meanwhile, when there is a defect in a battery, the possibility of damage to devices including the battery (e.g., EV, ESS) may increase. Accordingly, a method for detecting an abnormal state of the battery and reducing the possibility of damage to devices including the battery is required.

Embodiments disclosed in this document may provide a battery diagnosis device and an operating method thereof capable of extracting a diagnostic feature value used to diagnose an abnormality of a battery pack based on a battery cell voltage standard score for each OCV section of the battery pack.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery diagnosis device according to an embodiment disclosed in this document may include an acquisition unit that acquires pack data related to a state of a battery pack and cell data related to a state of a plurality of battery cells included in the battery pack, an identification unit that identifies, based on the pack data, a first OCV section in which a voltage standard score (Z-Score) difference between the plurality of battery cells decreases as an open circuit voltage (OCV) of the battery pack increases and a second OCV section in which the voltage standard score difference between the plurality of battery cells increases as the OCV of the battery pack increases, an extraction unit that extracts, based on the cell data, a diagnostic feature value from voltage standard scores of the plurality of battery cells corresponding to each of the first OCV section and the second OCV section and a diagnosis unit that diagnoses an abnormality of the battery pack based on the extracted diagnostic feature value.

In the battery diagnosis device according to an embodiment disclosed in this document, the pack data may include a graph representing the OCV with respect to a state of charge (SOC) of the battery pack, and the cell data may include a graph representing voltage standard scores of the plurality of battery cells with respect to the OCV of the battery pack.

In the battery diagnosis device according to an embodiment disclosed in this document, the identification unit may identify the first OCV section and the second OCV section based on a slope of the pack data.

In the battery diagnosis device according to an embodiment disclosed in this document, the identification unit may identify an OCV section, in which the slope of the pack data is equal to or lower than a designated value and the slope continuously changes, as the first OCV section, and identify an OCV section, in which the slope of the pack data exceeds the designated value and the slope continuously changes, as the second OCV section.

In the battery diagnosis device according to an embodiment disclosed in this document, the extraction unit may calculate the voltage standard score difference between the plurality of battery cells in the first OCV section, select a target battery cell having the largest voltage standard score difference from the remaining battery cells based on the calculated voltage standard score difference, and extract the diagnostic feature value based on the voltage standard score in the second OCV section of the target battery cell.

In the battery diagnosis device according to an embodiment disclosed in this document, the extraction unit may extract the diagnostic feature value based on Equation 1 below.

[Equation 1]

$$F = \frac{Z_2 - Z_1}{OCV_{max} - OCV_{min}}$$

(In Equation 1, F is the diagnostic feature value, $OCV_{min}$ is a minimum OCV value of the second OCV section, $OCV_{max}$ is a maximum OCV value of the second OCV section, $Z_1$ is a first voltage standard score of the target battery cell corresponding to the minimum OCV value, and $Z_2$ is a second voltage standard score of the target battery cell corresponding to the maximum OCV value)

In the battery diagnosis device according to an embodiment disclosed in this document, the diagnosis unit may diagnose an abnormality of the battery pack by comparing the diagnostic feature value with a threshold value.

The battery diagnosis device according to an embodiment disclosed in this document may further include an abnormality processing unit that performs an abnormality processing function based on an abnormality diagnosis result of the battery pack, and the abnormality processing function may include a notification function or a short circuit function.

An operating method of a battery diagnosis device according to an embodiment disclosed in this document may include an operation of acquiring pack data related to a state of a battery pack and cell data related to a state of a plurality of battery cells included in the battery pack, an operation of identifying, based on the pack data, a first OCV section in which a voltage standard score (Z-Score) difference between the plurality of battery cells decreases as an open circuit voltage (OCV) of the battery pack increases and a second OCV section in which the voltage standard score difference between the plurality of battery cells increases as the OCV of the battery pack increases, an operation of extracting, based on the cell data, a diagnostic feature value from the voltage standard scores of the plurality of battery cells corresponding to each of the first OCV section and the second OCV section, and an operation of diagnosing an abnormality of the battery pack based on the extracted diagnostic feature value.

In the operating method of the battery diagnosis device according to an embodiment disclosed in this document, the pack data may include a graph representing the OCV with respect to a state of charge (SOC) of the battery pack, and the cell data may include a graph representing voltage standard scores of the plurality of battery cells with respect to the OCV of the battery pack.

In the operating method of the battery diagnosis device according to an embodiment disclosed in this document, the operation of identifying the first OCV section and the second OCV section may include an operation of identifying the first OCV section and the second OCV section based on a slope of the pack data.

In the operating method of the battery diagnosis device according to an embodiment disclosed in this document, the operation of identifying the first OCV section and the second OCV section may include an operation of identifying an OCV section, in which the slope of the pack data is equal to or lower than a designated value and the slope continuously changes, as the first OCV section, and an operation of identifying an OCV section, in which the slope of the pack data exceeds the designated value and the slope continuously changes, as the second OCV section.

In the operating method of the battery diagnosis device according to an embodiment disclosed in this document, the operation of extracting the diagnostic feature values may include an operation of calculating the voltage standard score difference between the plurality of battery cells in the first OCV section, an operation of selecting a target battery cell having the largest voltage standard score difference from the remaining battery cells based on the calculated voltage standard score difference, and an operation of extracting the diagnostic feature value based on the voltage standard score in the second OCV section of the target battery cell.

In the operating method of the battery diagnosis device according to an embodiment disclosed in this document, the operation of extracting the diagnostic feature value may be based on the above Equation 1.

In the operating method of the battery diagnosis device according to an embodiment disclosed in this document, the operation of diagnosing the abnormality of the battery pack may include an operation of diagnosing the abnormality in the battery pack by comparing the diagnostic feature value with a threshold value.

## ADVANTAGEOUS EFFECTS

According to the embodiments disclosed in this document, the diagnosis accuracy can be improved by diagnosing an abnormality in a battery pack using a diagnostic feature value extracted based on a battery cell voltage standard score for each OCV section of the battery pack.

In addition, various effects can be provided that are directly or indirectly identified through this document.

## BRIEF DESCRIPTION OF THE DRAWINGS

FIG. 1 is a block diagram of a battery diagnosis device according to an embodiment.

FIG. 2 is a graph illustrating pack data related to a state of a battery pack acquired by a battery diagnosis device according to an embodiment.

FIG. 3 is a graph illustrating cell data related to a state of a plurality of battery cells acquired by a battery diagnosis device according to an embodiment.

FIG. 4 is an operation flowchart of a battery diagnosis device according to an embodiment.

## MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Various embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

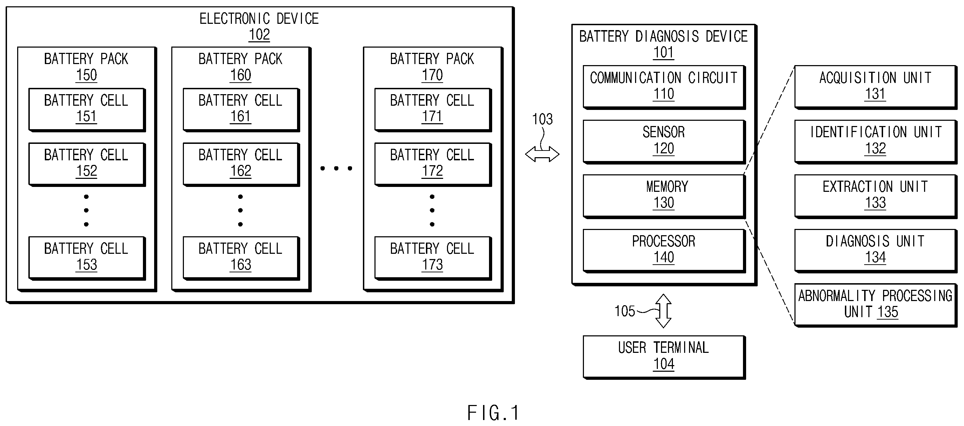

FIG. 1 is a block diagram of a battery diagnosis device according to an embodiment.

A battery diagnosis device 101 described below may be implemented as a battery management system (BMS) in an electronic device 102, and may also be implemented as various external devices such as a server, a cloud, a charger, or a charger/discharger.

Referring to FIG. 1, the battery diagnosis device 101 may be connected to the electronic device 102 and a user terminal 104 in a wired manner and/or wirelessly.

According to an embodiment, a connection 103 between the battery diagnosis device 101 and the electronic device 102 may be a communication connection established through a wired and/or wireless network. In an embodiment, the wired network may be based on local area network (LAN) communication or power line communication. In an embodiment, the wireless network may be based on a short-range communication network (e.g., Bluetooth, wireless fidelity (WiFi), or infrared data association (IrDA)), or a long-range communication network (e.g., a cellular network, a 4G network, a 5G network).

According to another embodiment, the connection 103 between the battery diagnosis device 101 and the electronic device 102 may be a connection established through a device-to-device communication method (e.g., bus, general purpose input and output (GPIO), serial peripheral interface (SPI), or mobile industry processor interface (MIPI)).

According to an embodiment, the electronic device 102 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to an embodiment, the electronic device 102 may include a plurality of battery packs 150, 160, and 170. Each of the plurality of battery packs 150, 160, and 170 may include a plurality of battery cells 151, 152, 153, 161, 162, 163, 171, 172, and 173. Here, each of the battery cells 151, 152, 153, 161, 162, 163, 171, 172, and 173 may be a single battery cell, and may also be a cell group in which at least two or more battery cells are connected in parallel in the battery packs 150, 160, or 170.

According to an embodiment, a connection 105 between the battery diagnosis device 101 and a user terminal 104 may be a communication connection established through a wired and/or wireless network.

According to an embodiment, the user terminal 104 may be a mobile device (e.g., a mobile phone, a laptop computer, a smart phone, a smart pad), or a personal computer (PC). According to an embodiment, the battery diagnosis device 101 may provide information related to diagnostic results of the battery unit 151, 153, or 155 to the user terminal 104.

According to an embodiment, the battery diagnosis device 101 may include a communication circuit 110, a sensor 120, a memory 130, and a processor 140. According to the embodiment, the battery diagnosis device 101 illustrated in FIG. 1 may further include at least one component (e.g., a display, an input device, or an output device) other than the components illustrated in FIG. 1, or may omit at least one component (e.g., a sensor 120) among the components illustrated in FIG. 1. For example, when the battery diagnosis device 101 is implemented as an external electronic device separate from the electronic device 102, such as a server or a cloud, the battery diagnosis device 101 may acquire state information of a plurality of battery packs 150, 160, and 170 and/or a plurality of battery cells 151, 152, 153, 161, 162, 163, 171, 172, and 173 using the communication circuit 110. In this case, the battery diagnosis device 101 may not include the sensor 120.

According to an embodiment, the communication circuit 110 may establish a wired communication channel and/or a wireless communication channel between the battery diagnosis device 101 and the electronic device 102 and/or the user terminal 104, and transmit and receive data to and from the electronic device 102 and/or the user terminal 104 through the established communication channel.

According to an embodiment, the sensor 120 may measure information (e.g., voltage, current, temperature, etc.) related to the state of the plurality of battery packs 150, 160, and 170 and/or the plurality of battery cells 151, 152, 153, 161, 162, 163, 171, 172, and 173 of the electronic device 102. For example, when the battery diagnosis device 101 is implemented as a battery management system (BMS) (e.g., a pack BMS and/or cell BMS) in the electronic device 102, the battery diagnosis device 101 may directly measure state values of the plurality of battery packs 150, 160, and 170 and/or the plurality of battery cells 151, 152, 153, 161, 162, 163, 171, 172, and 173 using the sensor 120.

According to an embodiment, the memory 130 may include a volatile memory and/or a nonvolatile memory.

According to an embodiment, the memory 130 may store data used by at least one component (e.g., a processor 140) of the battery diagnosis device 101. For example, the data may include software (or instructions related thereto), input data, or output data. In an embodiment, the instructions, when executed by the processor 140, may cause the battery diagnosis device 101 to perform operations defined by the instructions.

According to an embodiment, the memory 130 may include one or more software (e.g., an acquisition unit 131, an identification unit 132, an extraction unit 133, a diagnosis unit 134, and an abnormality processing unit 135).

According to an embodiment, the processor 140 may include a central processing unit, an application processor, a graphics processing unit, a neural processing unit (NPU), an image signal processor, a sensor hub processor, or a communication processor.

According to an embodiment, the processor 140 may execute software (e.g., the acquisition unit 131, the identification unit 132, the extraction unit 133, the diagnosis unit 134, and the abnormality processing unit 135) stored in the memory 130 to control at least one other component (e.g., hardware or software component) of the battery diagnosis device 101 connected to the processor 140, and execute various data processing or computations.

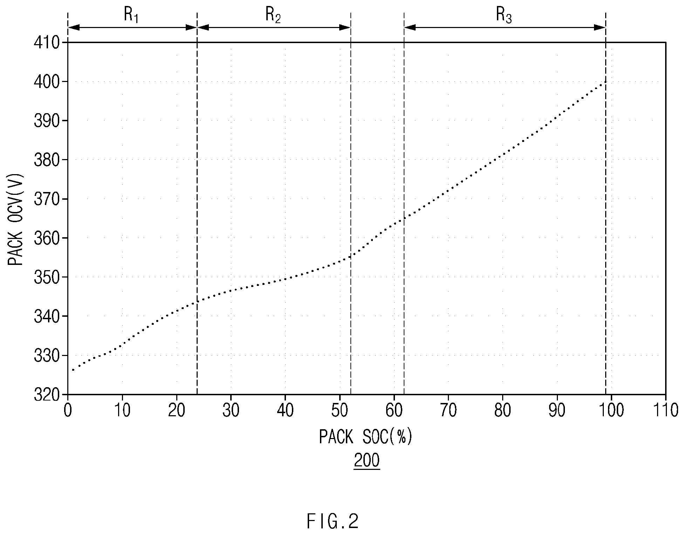

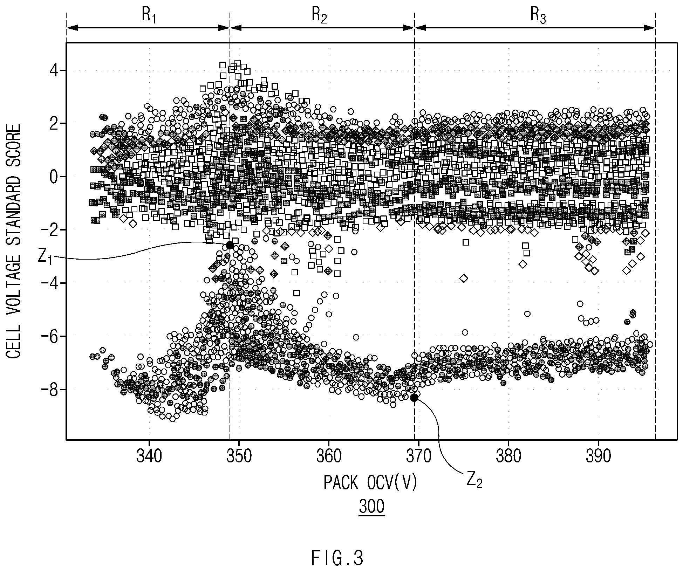

Hereinafter, referring to FIGS. 2 and 3, a method for diagnosing an abnormality of one battery pack 150 among the plurality of battery packs 150, 160, 170 by the battery diagnosis device 101 through the acquisition unit 131, the identification unit 132, the extraction unit 133, the diagnosis unit 134, and the abnormality processing unit 135 will be described. The abnormality diagnosis method of the battery pack 150, which will be described below, may be equally applied to all battery packs 150, 160, and 170 included in the electronic device 102.

FIG. 2 is a graph illustrating pack data related to a state of a battery pack acquired by a battery diagnosis device according to an embodiment. FIG. 3 is a graph illustrating cell data related to a state of a plurality of battery cells acquired by the battery diagnosis device according to an embodiment.

According to an embodiment, the acquisition unit 131 may acquire pack data related to the state of the battery pack 150. Here, the pack data may include a graph representing an open circuit voltage (OCV) for a state of charge (SOC) of the battery pack 150. In addition, the pack data may include a graph representing SOC-OCV in one of a plurality of charge/discharge cycles of the battery pack 150.

For example, the acquisition unit 131 may acquire pack data such as a graph 200 of FIG. 2. In the graph 200, the X-axis may represent the SOC of the battery pack 150, and the Y-axis may represent the OCV of the battery pack 150.

According to an embodiment of the present invention, the acquisition unit 131 may acquire cell data related to the state of the plurality of battery cells 151, 152, and 153 included in the battery pack 150. Here, the cell data may include a graph representing voltage standard scores (Z-scores) of the plurality of battery cells 151, 152, and 153 for the OCV of the battery pack 150. In addition, the cell data may include a graph representing pack OCV-cell voltage standard scores in each of a plurality of charge/discharge cycles of the plurality of battery cells 151, 152, and 153.

For example, the acquisition unit 131 may acquire cell data representing pack OCV-cell voltage standard scores in each of a plurality of charge/discharge cycles, such as a graph 300 of FIG. 3. In the graph 300, the X-axis may represent the OCV of the battery pack 150 and the Y-axis may represent the voltage standard scores of the plurality of battery cells 151, 152, and 153.

According to an embodiment, the identification unit 132 may identify a first OCV section and a second OCV section of the battery pack 150 based on the pack data acquired by the acquisition unit 131. Here, the first OCV section may mean a section, in which a voltage standard score difference between the plurality of battery cells 151, 152, 153 decreases, as the OCV of the battery pack 150 increases. In addition, the second OCV section may mean a section, in which the voltage standard score difference between the plurality of battery cells 151, 152, and 153 increases, as the OCV of the battery pack 150 increases.

According to an embodiment, the identification unit 132 may identify the first OCV section and the second OCV section based on a slope of the pack data. For example, the identification unit 132 may identify an OCV section, in which the slope of the SOC-OCV graph included in the pack data is less than or equal to a designated value and the slope continuously changes, as the first OCV section. In addition, the identification unit 132 may identify an OCV section, in which the slope exceeds a designated value and the slope continuously changes, as the second OCV section.

According to an embodiment, the identification unit 132 may identify the first OCV section and the second OCV section based on first-order differential data and second-order differential data of the pack data. The first-order differential data may be data representing a first-order differential value $dOCV/dSOC$ obtained by differentiating the OCV of the battery pack 150 with respect to the SOC. In addition, the second-order differential data may be data representing a second-order differential value $d^2OCV/dSOC^2$, which is obtained by differentiating the first-order differential value $(dOCV/dSOC)$ of the battery pack 150 with respect to SOC, with respect to SOC.

For example, the identification unit 132 may identify the first SOC section in which the first-order differential value $dOCV/dSOC$ of the battery pack 150 is less than or equal to a designated value based on the first-order differential data. The identification unit 132 may identify the second SOC section in which the second differentiation value $d^2OCV/dSOC^2$ of the battery pack 150 is not 0 among the first SOC sections based on the second-order differential data. The identification unit 132 may identify an OCV section corresponding to the second SOC section in the pack data as the first OCV section.

As another example, the identification unit 132 may identify a third SOC section in which the first-order differential value $dOCV/dSOC$ of the battery pack 150 exceeds a designated value based on the first-order differential data. The identification unit 132 may identify a fourth SOC section in which the second differential value $d^2OCV/dSOC^2$ of the battery pack 150 is not 0 among the third SOC sections based on the second-order differential data. The identification unit 132 may identify an OCV section corresponding to the fourth SOC section in the pack data as the second OCV section.

According to an embodiment, the identification unit 132 may identify the third OCV section of the battery pack 150 based on the pack data. Here, the third OCV section may mean a section in which the voltage standard score difference between the plurality of battery cells 151, 152, and 153 is constant as the OCV of the battery pack 150 increases.

According to an embodiment, the identification unit 132 may identify the third OCV section based on the slope of the pack data. For example, the identification unit 132 may identify an OCV section, in which the slope of the SOC-OCV graph included in the pack data is maintained, as the third OCV section.

According to an embodiment, the identification unit 132 may identify the third OCV section based on the second-order differential data of the pack data. For example, the identification unit 132 may identify a fifth SOC section in which the second differential value $d^2OCV/dSOC^2$ of the battery pack 150 becomes 0 based on the second-order differential data. The identification unit 132 may identify the OCV section corresponding to the fifth SOC section in the pack data as the third OCV section.

Referring to FIG. 2, the identification unit 132 may identify a first OCV section $R_1$ whose slope of the graph 200 is less than or equal to a designated value and continuously changes, a second OCV section $R_2$ whose slope exceeds a designated value and continuously changes, and/or a third OCV section $R_3$ whose slope is constant.

The OCV sections $R_1$, $R_2$, and $R_3$ shown in the graph 300 of FIG. 3 may be the first OCV section $R_1$, the second OCV section $R_2$, and the third OCV section $R_3$ identified by the identification unit 132. Referring to FIG. 3, it can be checked that in the first OCV section $R_1$ of the graph 300, the voltage standard score difference between the plurality of battery cells 151, 152, and 153 decreases, in the second OCV section $R_2$, the voltage standard score difference between the plurality of battery cells 151, 152, and 153 increases, and in the third OCV section $R_3$, the voltage standard score difference between the plurality of battery cells 151, 152, and 153 is constant.

Referring again to FIG. 1, the extraction unit 133 may extract a diagnostic feature value based on the cell data acquired by the acquisition unit 131. According to an embodiment, the extraction unit 133 may extract the diagnostic feature value from voltage standard scores of the plurality of battery cells 151, 152, and 153 corresponding to each of the first OCV section and the second OCV section identified by the identification unit 132.

Referring to FIG. 3, the extraction unit 133 may calculate the voltage standard score difference between the plurality of battery cells 151, 152, and 153 in the first OCV section $R_1$. The extraction unit 133 may select a target battery cell (e.g., 151) having the largest voltage standard score difference from the remaining battery cells (e.g., 152 and 153) based on the calculated voltage standard score difference.

According to an embodiment, the extraction unit 133 may extract a diagnostic feature value based on the voltage standard score in the second OCV section $R_2$ of the target battery cell (e.g., 151). Specifically, the extraction unit 133 may extract the diagnostic feature value based on a first voltage standard score $Z_1$ and a second voltage standard score $Z_2$ in the second OCV section $R_2$ of the target battery cell (e.g., 151).

According to an embodiment, the extraction unit 133 may extract the diagnostic feature value based on Equation 1 below.

[Equation 1]

$$ F = \frac{Z_2 - Z_1}{OCV_{max} - OCV_{min}} $$

In Equation 1, F is the diagnostic feature value, $OCV_{min}$ is the minimum OCV value of the second OCV section $R_2$, $OCV_{max}$ is the maximum OCV value of the second OCV section $R_2$, $Z_1$ is the first voltage standard score of the target battery cell (e.g., 151) corresponding to the minimum OCV value, and $Z_2$ is the second voltage standard score of the target battery cell (e.g., 151) corresponding to the maximum OCV value.

Referring again to FIG. 1, the diagnosis unit 134 may diagnose an abnormality of the battery pack 150 based on the diagnostic feature value extracted by the extraction unit 133.

According to an embodiment, the diagnosis unit 134 may diagnose the abnormality of the battery pack 150 by comparing the diagnosis feature value with a preset threshold value. For example, the diagnosis unit 134 may diagnose the battery pack 150 as an abnormal battery pack when the diagnosis feature value is equal to or greater than (exceeds) the preset threshold value.

According to another embodiment, the diagnosis unit 134 may diagnose the abnormality of the battery pack 150 by comparing an absolute value of the diagnosis feature value with a preset threshold value. For example, the diagnosis unit 134 may diagnose the battery pack 150 as an abnormal battery pack when the absolute value of the diagnosis feature value is equal to or greater than (exceeds) the preset threshold value.

According to an embodiment, the abnormality processing unit 135 may perform an abnormality processing function based on an abnormality diagnosis result of the battery pack 150. Here, the abnormality processing function may include a notification function or a short circuit function.

According to an embodiment, the abnormality processing unit 135 may transmit the abnormality diagnosis result of the battery pack 150 to the user terminal 104 connected through a wired and/or wireless network.

According to an embodiment, the abnormality processing unit 135 may isolate the abnormal battery pack from the electronic device 102 based on the abnormality diagnosis result of the battery pack 150. Here, the isolation may include electrical and/or mechanical isolation.

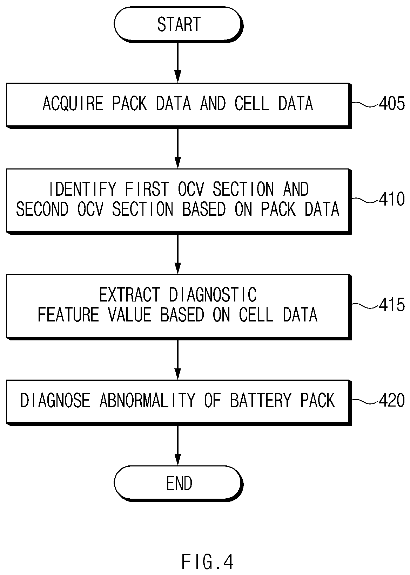

FIG. 4 is an operation flowchart of a battery diagnosis device according to an embodiment. FIG. 4 may be explained using the components of FIG. 1.

The embodiment illustrated in FIG. 4 is only an embodiment, and the order of steps according to various embodiments of the present invention may be different from that illustrated in FIG. 4, and some steps illustrated in FIG. 4 may be omitted, the order between steps may be changed, or steps may be merged.

Referring to FIG. 4, in operation 405, the battery diagnosis device 101 may acquire pack data related to a state of the battery pack 150 and cell data related to a state of a plurality of battery cells 151, 152, and 153 included in the battery pack 150.

For example, the pack data may include a graph representing an OCV with respect to a SOC of the battery pack 150. In addition, the pack data may include a graph representing an SOC-OCV in one of a plurality of charge/discharge cycles of the battery pack 150.

For example, the cell data may include a graph representing voltage standard scores (Z-scores) of the plurality of battery cells 151, 152, and 153 with respect to the OCV of the battery pack 150. In addition, the cell data may include a graph representing a pack OCV-cell voltage standard score in each of the plurality of charge/discharge cycles of the plurality of battery cells 151, 152, and 153.

In operation 410, the battery diagnosis device 101 may identify a first OCV section and a second OCV section of the battery pack 150 based on the pack data acquired in operation 405. Here, the first OCV section may mean a section in which a voltage standard score difference between the plurality of battery cells 151, 152, and 153 decreases as the OCV of the battery pack 150 increases. In addition, the second OCV section may mean a section in which the voltage standard score difference between the plurality of battery cells 151, 152, and 153 increases as the OCV of the battery pack 150 increases.

According to an embodiment, the battery diagnosis device 101 may identify the first OCV section and the second OCV section based on a slope of the pack data. For example, the battery diagnosis device 101 may identify an OCV section, in which the slope of the SOC-OCV graph included in the pack data is less than or equal to a designated value and the slope continuously changes, as the first OCV section. In addition, the battery diagnosis device 101 may identify the OCV section, in which the slope exceeds the designated value and the slope continuously changes, as a second OCV section.

According to an embodiment, the battery diagnosis device 101 may identify the first OCV section and the second OCV section based on first-order differential data and second-order differential data of the pack data. The first-order differential data may be data indicating first-order differential value $dOCV/dSOC$ obtained by differentiating the OCV of the battery pack 150 with respect to the SOC. In addition, the second-order differential data may be data indicating second differential value $d^2OCV/dSOC^2$ obtained by differentiating the first-order differential value $dOCV/dSOC$ of the battery pack 150 with respect to the SOC.

For example, the battery diagnosis device 101 may identify a first SOC section in which the first-order differential value $dOCV/dSOC$ of the battery pack 150 is less than or equal to a designated value based on the first-order differential data. The battery diagnosis device 101 may identify a second SOC section in which the second differential value $d^2OCV/dSOC^2$ of the battery pack 150 is not 0 among the first SOC sections based on the second-order differential data. The battery diagnosis device 101 may identify an OCV section corresponding to the second SOC section in the pack data as the first OCV section.

As another example, the battery diagnosis device 101 may identify a third SOC section in which the first-order differential value $dOCV/dSOC$ of the battery pack 150 exceeds a designated value based on the first-order differential data. The battery diagnosis device 101 may identify a fourth SOC section in which the second differentiation value $d^2OCV/dSOC^2$ of the battery pack 150 is not 0 among the third SOC sections based on the second-order differential data. The battery diagnosis device 101 may identify the OCV section corresponding to the fourth SOC section in the pack data as the second OCV section.

According to an embodiment, the battery diagnosis device 101 may identify the third OCV section of the battery pack 150 based on the pack data. Here, the third OCV section may mean a section, in which the voltage standard score difference between the plurality of battery cells 151, 152, and 153 is constant, as the OCV of the battery pack 150 increases.

According to an embodiment, the battery diagnosis device 101 may identify the third OCV section based on a slope of the pack data. For example, the battery diagnosis device 101 may identify the OCV section, in which a slope of the SOC-OCV graph included in the pack data is maintained, as the third OCV section.

According to an embodiment, the battery diagnosis device 101 may identify the third OCV section based on the second-order differential data of the pack data. For example, the battery diagnosis device 101 may identify a fifth SOC section in which the second differential value $d^2OCV/dSOC^2$ of the battery pack 150 becomes 0 based on the second-order differential data. The battery diagnosis device 101 may identify the OCV section corresponding to the fifth SOC section in the pack data as the third OCV section.

In operation 415, the battery diagnosis device 101 may extract a diagnostic feature value based on the cell data acquired in operation 405. According to an embodiment, the battery diagnosis device 101 may extract a diagnostic feature value from voltage standard scores of a plurality of battery cells 151, 152, 153 corresponding to each of the first OCV section and the second OCV section identified in operation 410.

According to an embodiment, the battery diagnosis device 101 may calculate a voltage standard score difference between the plurality of battery cells 151, 152, and 153 in the first OCV section. The battery diagnosis device 101 may select a target battery cell (e.g., 151) having the largest voltage standard score difference from the remaining battery cells (e.g., 152, and 153) based on the calculated voltage standard score difference.

According to an embodiment, the battery diagnosis device 101 may extract the diagnostic feature value based on a voltage standard score in the second OCV section of the target battery cell (e.g., 151).

According to an embodiment, the battery diagnosis device 101 may extract the diagnostic feature value based on the above Equation 1.

In operation 420, the battery diagnosis device 101 may diagnose an abnormality of the battery pack 150 based on the diagnostic feature value extracted in operation 415.

According to an embodiment, the battery diagnosis device 101 may diagnose the abnormality of the battery pack 150 by comparing the diagnostic feature value with a preset threshold value. For example, the battery diagnosis device 101 may diagnose the battery pack 150 as an abnormal battery pack when the diagnostic feature value is equal to or greater than (or, exceeds) the preset threshold value.

According to another embodiment, the battery diagnosis device 101 may diagnose an abnormality of the battery pack 150 by comparing an absolute value of the diagnosis feature value with a preset threshold value. For example, the battery diagnosis device 101 may diagnose the battery pack 150 as an abnormal battery pack when the absolute value of the diagnosis feature value is equal to or greater than (or, exceeds) the preset threshold value.

According to an embodiment, the battery diagnosis device 101 may perform an abnormality processing function based on an abnormality diagnosis result of the battery pack 150. Here, the abnormality processing function may include a notification function or a short circuit function.

According to an embodiment, the battery diagnosis device 101 may transmit an abnormality diagnosis result of the battery pack 150 to the user terminal 104 connected through a wired and/or wireless network.

According to an embodiment, the battery diagnosis device 101 may isolate the abnormal battery pack from the electronic device 102 based on the abnormal diagnosis result of the battery pack 150. Here, the isolation may include electrical and/or mechanical isolation.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

**Claims**

1. A battery diagnosis device comprising:

   an acquisition unit that acquires pack data related to a state of a battery pack and cell data related to a state of a plurality of battery cells included in the battery pack;
   an identification unit that identifies, based on the pack data, a first OCV section in which a voltage standard score (Z-Score) difference between the plurality of battery cells decreases as an open circuit voltage (OCV) of the battery pack increases and a second OCV section in which the voltage standard score difference between the plurality of battery cells increases as the OCV of the battery pack increases;
   an extraction unit that extracts, based on the cell data, a diagnostic feature value from voltage standard scores of the plurality of battery cells corresponding to each of the first OCV section and the second OCV section; and
   a diagnosis unit that diagnoses an abnormality of the battery pack based on the extracted diagnostic feature value.

2. The battery diagnosis device of claim 1, wherein the pack data includes a graph representing the OCV with respect to a state of charge (SOC) of the battery pack, and
the cell data includes a graph representing voltage standard scores of the plurality of battery cells with respect to the OCV of the battery pack.

3. The battery diagnosis device of claim 2, wherein the identification unit identifies the first OCV section and the second OCV section based on a slope of the pack data.

4. The battery diagnosis device of claim 3, wherein the identification unit

   identifies an OCV section, in which the slope of the pack data is equal to or lower than a designated value and the slope continuously changes, as the first OCV section, and
   identifies an OCV section, in which the slope of the pack data exceeds the designated value and the slope continuously changes, as the second OCV section.

5. The battery diagnosis device of claim 2, wherein the extraction unit

   calculates the voltage standard score difference between the plurality of battery cells in the first OCV section,
   selects a target battery cell having the largest voltage standard score difference from the remaining battery cells based on the calculated voltage standard score difference, and
   extracts the diagnostic feature value based on the voltage standard score in the second OCV section of the target battery cell.

6. The battery diagnosis device of claim 5, wherein the extraction unit extracts the diagnostic feature value based on Equation 1 below,

   [Equation 1]

   $$F = \frac{Z_2 - Z_1}{OCV_{max} - OCV_{min}}$$

   (In Equation 1, F is the diagnostic feature value, $OCV_{min}$ is a minimum OCV value of the second OCV section, $OCV_{max}$ is a maximum OCV value of the second OCV section, $Z_1$ is a first voltage standard score of the target battery cell corresponding to the minimum OCV value, and $Z_2$ is a second voltage standard score of the target battery cell corresponding to the maximum OCV value).

7. The battery diagnosis device of claim 1, wherein the diagnosis unit diagnoses an abnormality of the battery pack by comparing the diagnostic feature value with a threshold value.

8. The battery diagnosis device of claim 1, further comprising:

   an abnormality processing unit that performs an abnormality processing function based on an abnormality diagnosis result of the battery pack,
   wherein the abnormality processing function includes a notification function or a short circuit function.

9. An operating method of a battery diagnosis device, comprising:

   an operation of acquiring pack data related to a state of a battery pack and cell data related to a state of a plurality of battery cells included in the battery pack;
   an operation of identifying, based on the pack data, a first OCV section in which a voltage standard score (Z-Score) difference between the plurality of battery cells decreases as an open circuit voltage (OCV) of the battery pack increases and a second OCV section in which the voltage standard score difference between the plurality of battery cells increases as the OCV of the battery pack increases;
   an operation of extracting, based on the cell data, a diagnostic feature value from the voltage standard scores of the plurality of battery cells corresponding to each of the first OCV section and the second OCV section; and
   an operation of diagnosing an abnormality of the battery pack based on the extracted diagnostic feature value.

10. The operating method of claim 9, wherein the pack data includes a graph representing the OCV with respect to a state of charge (SOC) of the battery pack, and
the cell data includes a graph representing voltage standard scores of the plurality of battery cells with respect to the OCV of the battery pack.

11. The operating method of claim 10, wherein the operation of identifying the first OCV section and the second OCV section includes an operation of identifying the first OCV section and the second OCV section based on a slope of the pack data.

12. The operating method of claim 11, wherein the operation of identifying the first OCV section and the second OCV section includes:

an operation of identifying an OCV section, in which the slope of the pack data is equal to or lower than a designated value and the slope continuously changes, as the first OCV section; and
an operation of identifying an OCV section, in which the slope of the pack data exceeds the designated value and the slope continuously changes, as the second OCV section.

13. The operating method of claim 9, wherein the operation of extracting the diagnostic feature values includes:

an operation of calculating the voltage standard score difference between the plurality of battery cells in the first OCV section;
an operation of selecting a target battery cell having the largest voltage standard score difference from the remaining battery cells based on the calculated voltage standard score difference; and
an operation of extracting the diagnostic feature value based on the voltage standard score in the second OCV section of the target battery cell.

14. The operating method of claim 13, wherein the operation of extracting the diagnostic feature value may be based on Equation 1 below,

[Equation 1]

$$F = \frac{Z_2 - Z_1}{OCV_{max} - OCV_{min}}$$

(In Equation 1, F is the diagnostic feature value, $OCV_{min}$ is a minimum OCV value of the second OCV section, $OCV_{max}$ is a maximum OCV value of the second OCV section, $Z_1$ is a first voltage standard score of the target battery cell corresponding to the minimum OCV value, and $Z_2$ is a second voltage standard score of the target battery cell corresponding to the maximum OCV value).

15. The operating method of claim 9, wherein the operation of diagnosing the abnormality of the battery pack includes an operation of diagnosing the abnormality in the battery pack by comparing the diagnostic feature value with a threshold value.

ELECTRONIC DEVICE
102

BATTERY PACK
150

BATTERY CELL
151

BATTERY CELL
152

BATTERY CELL
153

BATTERY PACK
160

BATTERY CELL
161

BATTERY CELL
162

BATTERY CELL
163

BATTERY PACK
170

BATTERY CELL
171

BATTERY CELL
172

BATTERY CELL
173

103

BATTERY DIAGNOSIS DEVICE
101

COMMUNICATION CIRCUIT
110

SENSOR
120

MEMORY
130

PROCESSOR
140

ACQUISITION UNIT
131

IDENTIFICATION UNIT
132

EXTRACTION UNIT
133

DIAGNOSIS UNIT
134

ABNORMALITY PROCESSING
UNIT 135

105

USER TERMINAL
104

EP 4 760 317 A1

FIG.1

FIG.2

FIG.3

```
                    ┌─────────────┐
                    │    START    │
                    └──────┬──────┘
                           │
                           ▼
          ┌──────────────────────────────────────┐
          │  ACQUIRE PACK DATA AND CELL DATA      │───405
          └──────────────────┬───────────────────┘
                             │
                             ▼
          ┌──────────────────────────────────────┐
          │     IDENTIFY FIRST OCV SECTION AND    │───410
          │  SECOND OCV SECTION BASED ON PACK DATA │
          └──────────────────┬───────────────────┘
                             │
                             ▼
          ┌──────────────────────────────────────┐
          │         EXTRACT DIAGNOSTIC            │───415
          │   FEATURE VALUE BASED ON CELL DATA    │
          └──────────────────┬───────────────────┘
                             │
                             ▼
          ┌──────────────────────────────────────┐
          │ DIAGNOSE ABNORMALITY OF BATTERY PACK  │───420
          └──────────────────┬───────────────────┘
                             │
                             ▼
                    ┌─────────────┐
                    │     END     │
                    └─────────────┘
```

FIG.4

## INTERNATIONAL SEARCH REPORT

| International application No. |
| --- |
| **PCT/KR2025/001820** |

### A. CLASSIFICATION OF SUBJECT MATTER

**G01R 31/396**(2019.01)i; **G01R 31/3835**(2019.01)i; **G01R 19/165**(2006.01)i; **G01R 19/30**(2006.01)i

According to International Patent Classification (IPC) or to both national classification and IPC

### B. FIELDS SEARCHED

Minimum documentation searched (classification system followed by classification symbols)

G01R 31/396(2019.01); G01R 31/36(2006.01); G01R 31/367(2019.01); G01R 31/52(2020.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), OCV(Open Circuit Voltage), 표준 점수(Z-score), 진단 특징 값 (diagnostic feature value)

### C. DOCUMENTS CONSIDERED TO BE RELEVANT

| Category* | Citation of document, with indication, where appropriate, of the relevant passages | Relevant to claim No. |
| --- | --- | --- |
| A | KR 10-2016-0046547 A (LG CHEM, LTD.) 29 April 2016 (2016-04-29)<br>　　See paragraphs [0102]-[0124] and figure 1. | 1-15 |
| A | KR 10-2424165 B1 (SK ON CO., LTD.) 25 July 2022 (2022-07-25)<br>　　See claim 1 and figures 2-7. | 1-15 |
| A | JP 2023-152320 A (TOYOTA INDUSTRIES CORP.) 17 October 2023 (2023-10-17)<br>　　See claim 1 and figures 1-8. | 1-15 |
| A | KR 10-2023-0139969 A (SEOUL NATIONAL UNIVERSITY R&DB FOUNDATION) 06 October 2023 (2023-10-06)<br>　　See claims 1-3 and figure 1. | 1-15 |
| A | KR 10-2023-0063786 A (LG ENERGY SOLUTION, LTD.) 09 May 2023 (2023-05-09)<br>　　See claim 1 and figures 2-4. | 1-15 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | "X" | document of particular relevance; the claimed invention cannot be considered novel or cannot be considered to involve an inventive step when the document is taken alone |
| "D" | document cited by the applicant in the international application | | |
| "E" | earlier application or patent but published on or after the international filing date | "Y" | document of particular relevance; the claimed invention cannot be considered to involve an inventive step when the document is combined with one or more other such documents, such combination being obvious to a person skilled in the art |
| "L" | document which may throw doubts on priority claim(s) or which is cited to establish the publication date of another citation or other special reason (as specified) | | |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **12 May 2025** | **12 May 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2025/001820**

| Patent document cited in search report | | | Publication date (day/month/year) | Patent family member(s) | | | Publication date (day/month/year) |
|---|---|---|---|---|---|---|---|
| KR | 10-2016-0046547 | A | 29 April 2016 | KR | 10-1711258 | B1 | 28 February 2017 |
| KR | 10-2424165 | B1 | 25 July 2022 | CN | 116008841 | A | 25 April 2023 |
| | | | | US | 2023-0132102 | A1 | 27 April 2023 |
| JP | 2023-152320 | A | 17 October 2023 | None | | | |
| KR | 10-2023-0139969 | A | 06 October 2023 | KR | 10-2785035 | B1 | 20 March 2025 |
| KR | 10-2023-0063786 | A | 09 May 2023 | CN | 116917751 | A | 20 October 2023 |
| | | | | EP | 4296699 | A1 | 27 December 2023 |
| | | | | JP | 2024-513368 | A | 25 March 2024 |
| | | | | US | 2025-0015625 | A1 | 09 January 2025 |
| | | | | WO | 2023-080649 | A1 | 11 May 2023 |

Form PCT/ISA/210 (patent family annex) (July 2022)

**EP 4 760 317 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240021601